# EUROPÄISCHE PATENTSCHRIFT

(11) **EP 0 654 166 B1**
(45) Veröffentlichungstag und Bekanntmachung des Hinweises auf die Patenterteilung: **17.04.1996**
(21) Anmeldenummer: 93912609.0
(22) Anmeldetag: 23.06.1993
(51) Int. Cl.: G11C 11/401

(54) **DRAM-ZELLENANORDNUNG**
DRAM CELL ASSEMBLY
CONFIGURATION DE CELLULES DRAM

(30) Priorität: 10.08.1992 DE 4226454
(43) Veröffentlichungstag der Anmeldung: 24.05.1995
(73) Patentinhaber: SIEMENS AKTIENGESELLSCHAFT, D-80333 München (DE)
(72) Erfinder: RÖSNER, Wolfgang, D-81739 München (DE)
(86) Internationale Anmeldenummer: DE9300542
(87) Internationale Veröffentlichungsnummer: WO9403898

(56) Entgegenhaltungen:
- DE-C- 3 930 639
- GB-A- 2 247 105
- US-A- 4 970 564

## Beschreibung

Zur Erhöhung der Integrationsdichte in DRAM-Zellenanordnungen werden einerseits DRAM-Zellen auf reduzierten Platzbedarf optimiert, andererseits wird die Anordnung der DRAM-Zellen in einer DRAM-Zellenanordnung zueinander optimiert.

Eine DRAM-Zelle mit reduziertem Platzbedarf ist die sogenannte Stacked-Capacitor-DRAM-Zelle. Sie umfaßt einen MOS-Transistor und einen Speicherkondensator, wobei der MOS-Transistor in einem Siliziumsubstrat angeordnet ist und der Speicherkondensator aus zwei dotierten Polysiliziumschichten und einer dazwischen angeordneten dielektrischen Schicht besteht, die an der Oberfläche des Substrats angeordnet sind. Der Speicherkondensator überdeckt dabei ganz oder teilweise diejenige Fläche, die von dem Transistor belegt wird. Der MOS-Transistor wird als Zelltransistor bezeichnet.

Eine weitere Reduzierung des Platzbedarfs wird bei der Stacked-Capacitor-DRAM-Zelle dadurch erzielt, daß der Speicherkondensator oberhalb einer Bitleitung angeordnet ist. Diese Variante der Stacked-Capacitor-DRAM-Zelle wird als Buried-Bitline-Stacked-Capacitor-(BBSTC)-DRAM-Zelle bezeichnet. Dabei muß eine Verbindung zwischen dem MOS-Transistor und dem Speicherknoten des Speicherkondensators, d. h. derjenigen Elektrode des Speicherkondensators, auf der die Information gespeichert wird, hergestellt werden. Eine solche Verbindung wird als Zellkontakt bezeichnet.

Die Anordnung der Zellen hängt auch mit ihrer schaltungstechnischen Ansteuerung zusammen. Zum Auslesen der gespeicherten Information wird eine Wortleitung aktiviert, wodurch alle an dieser Leitung liegenden Transistoren leitend werden und damit die gespeicherten Ladungen zu jeweils einer zugeordneten Bitleitung abfließen lassen. Anschließend werden die Spannungen von zwei Bitleitungen in einem Leseverstärker verglichen. Die eine Bitleitung stellt dabei die Verbindung von der zu bewertenden Zelle zum Leseverstärker dar, während an der anderen Bitleitung momentan keine Zelle aktiv sein darf (Referenzbitleitung). Die erste Bitleitung wird als angesprochene Bitleitung bezeichnet, sie ist mit einem Zelltransistor verbunden, dessen Gate von der aktivierten Wortleitung gebildet wird. Die Referenzbitleitung wird auch als nicht angesprochen bezeichnet. Liegen angesprochene und nicht angesprochene Bitleitungen immer abwechselnd nebeneinander, dann kann jeweils ein Paar benachbarter Bitleitungen von einem Leseverstärker bewertet werden. Diese Zellanordnung wird als folded bitline bezeichnet.

Aus S. Kimura et al, IEDM'88, S. 596 ff. und S. Kimura et al, IEEE Trans. Elect. Dev., Bd. 37 (1990), S. 737 ff. ist eine BBSTC-DRAM-Zelle bekannt, in der Kanalgebiet und Source der Zelltransistoren unter einem Winkel von etwa 45° zu den Wortleitungen und den Bitleitungen verlaufen. Die Wortleitungen und die Bitleitungen sind dabei zueinander rechtwinklig angeordnet. Zwischen Draingebiet und Kanalgebiet sind die aktiven Gebiete abgewinkelt. Dadurch ist es möglich, Zellkontakte mit Hilfe einer Spacertechnik selbstjustiert durch die Wortleitungs- und Bitleitungsebene hindurch auf n⁺-dotiertes Gebiet zu öffnen, welches in das Draingebiet des Zelltransistors übergeht. Der Speicherknoten wird überlappend zu diesem Zellkontakt hergestellt.

Die bekannte Zellanordnung ist eine folded bitline-Anordnung. Dabei liegen die Zellkontakte relativ eng beieinander. Die Bitleitungskontakte, die auf die Source-Gebiete der MOS-Transistoren reichen, sind dagegen wegen des abgewinkelten Verlaufs des aktiven Gebietes relativ weit voneinander entfernt. Dadurch ergeben sich in der Ebene der durch Feldisolation voneinander getrennten aktiven Gebiete einerseits relativ enge Abstände und andererseits relativ große Flecken ungenützten Gebietes. Eine DRAM-Zellenanordnung gemäß dem Oberbegriff des Patentanspruchs 1 ist aus der US-A-4 970 564 bekannt.

Der Erfindung liegt das Problem zugrunde, eine DRAM-Zellenanordnung anzugeben, mit der eine gleichmäßigere Ausnutzung der zur Verfügung stehenden Fläche in der Ebene Feldisolation/aktives Gebiet der MOS-Transistoren ermöglicht wird. Die Zellenanordnung soll insbesondere geeignet sein für Buried-Bitline-Stacked-Capacitor-DRAM-Zellen.

Dieses Problem wird erfindungsgemäß gelöst in einer DRAM-Zellenanordnung nach Anspruch 1. Dabei sind in je zwei Speicherzellen, die jeweils einen MOS-Transistor als Zelltransistor und ein Speicherelement umfassen, die MOS-Transistoren als Transistorpaar ausgebildet, deren Sourcegebiete miteinander und über einen gemeinsamen Bitleitungskontakt mit einer Bitleitung verbunden sind. Die MOS-Transistoren weisen dabei eine lineare Anordnung von Draingebiet, Kanalgebiet und Sourcegebiet auf, die in Richtung der Bitleitungen ausgerichtet ist und die im wesentlichen unterhalb einer zugehörigen Bitleitung angeordnet ist. An das Draingebiet jedes MOS-Transistors grenzt ein Anschlußgebiet an, über das ein Zellkontakt zu dem Speicherelement besteht. Das Anschlußgebiet ist jeweils seitlich der zugehörigen Bitleitung angeordnet. Durch die lineare Anordnung in den MOS-Transistoren ist die Stromverteilung im Zelltransistor homogen, was sich günstig auf die elektrischen Eigenschaften der Speicherzelle auswirkt. Durch die seitliche Anordnung der Anschlußgebiete an die jeweiligen Draingebiete wird eine hohe Integrationsdichte in der Zellenanordnung erzielt.

Dabei ist es besonders günstig, die an die Draingebiete eines Transistorpaares angrenzenden Anschlußgebiete an gegenüberliegenden Seiten der zugehörigen Seiten der Bitleitung anzuordnen und die Transistorpaare entlang jeder Bitleitung so anzuordnen, daß die Anschlußgebiete, die an einander zugewandte Draingebiete benachbarter Transistorpaare angrenzen, an jeweils gegenüberliegenden Seiten der zugehörigen Bitleitung angeordnet sind. Diese Anordnung ermöglicht, die Transistorpaare entlang einer ersten Bitleitung zu den Transistorpaaren entlang einer zweiten Bitleitung, die der ersten Bitleitung benachbart ist, so versetzt anzuordnen, daß die oberhalb des Kanalgebiets angeordneten Gateelektroden derjenigen MOS-Transistoren entlang der ersten Bitleitung, an deren Draingebieten die Anschlußgebiete an der der zweiten Bitleitung abgewandten Seite angeordnet sind und die Gateelektroden derjenigen Transistoren entlang der zweiten Bitleitung, an deren Draingebieten die Anschlußgebiete an der der ersten Bitleitung abgewandten Seite angeordnet sind, paarweise jeweils entlang einer Wortleitung angeordnet sind. Die Wortleitungen verlaufen dabei senkrecht zur Richtung der Bitleitungen.

Eine weitere Steigerung der Integrationsdichte wird erzielt durch Anordnung von Anschlußgebieten, die zwischen der ersten Bitleitung und der zweiten Bitleitung angeordnet sind, auf einer geometrischen Verbindungslinie, die parallel zu den Bitleitungen verläuft. Da zwischen der ersten Bitleitung und der zweiten Bitleitung sowohl Anschlußgebiete, die an Draingebiete von MOS-Transistoren entlang der ersten Bitleitung angrenzen, als auch Anschlußgebiete, die an Draingebiete von MOS-Transistoren entlang der zweiten Bitleitung angrenzen, angeordnet sind, ergibt sich dadurch der geringstmögliche Abstand zwischen benachbarten Bitleitungen.

Darüberhinaus sind entlang einer dritten Bitleitung, die der zweiten Bitleitung auf der der ersten Bitleitung abgewandten Seite benachbart ist, angeordnete MOS-Transistoren, an deren Draingebiet das Anschlußgebiet an der der zweiten Bitleitung zugewandten Seite angrenzt, und entlang der ersten Bitleitung angeordnete MOS-Transistoren, an deren Draingebiet das Anschlußgebiet an der der zweiten Bitleitung zugewandten Seite angrenzt, so zueinander versetzt angeordnet, daß die der zweiten Bitleitung zugewandten Anschlußgebiete jeweils paarweise entlang einer geometrischen Verbindungslinie angeordnet sind, die parallel zu den Wortleitungen verläuft.

In dieser Anordnung wiederholt sich die Anordnung der MOS-Transistorpaare entlang einer Bitleitung in jeder vierten Bitleitung. Entsprechend sind die Bitleitungskontakte auf benachbarten Bitleitungen jeweils um 1/4 von dem Abstand, den benachbarte Bitleitungskontakte auf ein und derselben Bitleitung aufweisen, gegeneinander versetzt. Eine solche Quarter-pitched-Anordnung ist sowohl bezüglich der Ausnutzung der zur Verfügung stehenden Fläche als auch bezüglich der Prozeßsicherheit bei der Öffnung der Bitleitungskontakte vorteilhaft.

Im Gegensatz zur folded bitline-Anordnung müssen in der quarter-pitched-Anordnung von einem Leseverstärker jeweils eine Bitleitung mit einem übernächsten Nachbarn verglichen werden, da hier jeweils 2 aktive und 2 inaktive Bitleitungen aufeinander folgen.

Eine Quarter-pitched-Anordnung ist aus S. Yoshikawa et al, Symp. on VLSI-Technol. 1989, S. 67 ff. zur Anordnung eines anderen Typs von Speicherzellen, die jeweils aus einem Auswahltransistor und einem im Substrat realisierten Grabenkondensator als Speicherkondensator bestehen, bekannt.

In der erfindungsgemäßen DRAM-Anordnung mit Quarterpitched-layout ist bei der Feldisolation der aktiven Gebiete gegeneinander ein gleichmäßiger Isolationsabstand realisierbar. Das ermöglicht die Verwendung von Grabenisolationen als Feldisolationen, ohne daß dabei Probleme wegen ungleichmäßiger Grabenbreite befürchtet werden müssen.

Die erfindungsgemäße DRAM-Anordnung ist besonders vorteilhaft für Buried-Bitline-Stacked-Capacitor-(BBSTC)-DRAM-Zellen geeignet.

Weitere Ausgestaltungen der Erfindung gehen aus den übrigen Ansprüchen hervor.

Im folgenden wird die Erfindung anhand eines Ausführungsbeispiels und der Figuren näher erläutert.

Fig. 1 zeigt einen Schnitt durch eine DRAM-Zellenanordnung parallel zur Oberfläche des Substrats in der Ebene Feldisolation/aktive Gebiete.

Fig. 2 zeigt ein Layout von Wort- und Bitleitungsebene und der Ebene Feldisolation/aktive Gebiete der MOS-Transistoren.

Fig. 3 zeigt einen Schnitt durch ein Transistorpaar einer erfindungsgemäßen DRAM-Zellenanordnung.

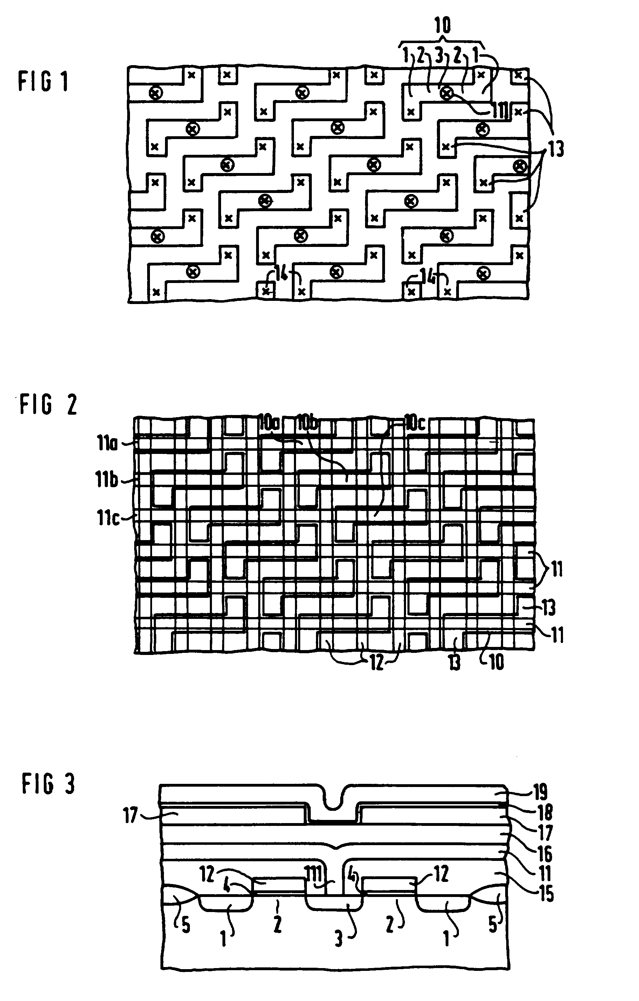

In einem Substrat sind eine Vielzahl von MOS-Transistoren angeordnet, die jeweils Auswahltransistor einer Speicherzelle sind. Jeder MOS-Transistor umfaßt ein Draingebiet 1, ein Kanalgebiet 2 mit zugehöriger Gateelektrode und ein Sourcegebiet 3 (s. Fig. 1). Je zwei MOS-Transistoren sind als Transistorpaar 10 ausgebildet, wobei Draingebiet 1, Kanalgebiet 2 und Sourcegebiet 3 jeweils geradlinig angeordnet sind. Die MOS-Transistoren eines Transistorpaares 10 sind dabei spiegelsymetrisch zueinander angeordnet. Sie treffen mit ihrem Sourcegebiet 3 zusammen. Sie weisen ein gemeinsames Sourcegebiet 3 auf.

Die Transistorpaare 10 sind jeweils in Richtung von in einer Bitleitungsebene verlaufenden Bitleitungen 11 (s. Fig. 2) ausgerichtet. Die Transistorpaare 10 sind dabei jeweils im wesentlichen unterhalb einer zugehörigen Bitleitung 11 angeordnet.

Senkrecht zu den Bitleitungen 11 verlaufen in einer Wortleitungsebene Wortleitungen 12 (s. Fig. 2). Die Wortleitungen 12 sind jeweils oberhalb des Kanalgebiets 2 angeordnet und mit der zugehörigen Gateelektrode verbunden. Sie verlaufen senkrecht zur geradlinigen Anordnung von Draingebiet 1, Kanalgebiet 2 und Sourcegebiet 3.

Über einen Bitleitungskontakt 111 ist das gemeinsame Sourcegebiet 3 jedes Transistorpaares 10 mit der zugehörigen Bitleitung 11 elektrisch verbunden. Im Substrat sind an die Draingebiete 1 angrenzend Anschlußgebiete 13 angeordnet. Die Anschlußgebiete 13 sind seitlich der Bitleitungen 11 angeordnet. Die Anschlußgebiete 13 an den Draingebieten 1 eines Transistorpaares 10 sind dabei jeweils auf entgegengesetzten Seiten der zugehörigen Bitleitung 11 angeordnet.

Entlang jeder Bitleitung 11 sind die Transistorpaare 10 jeweils so angeordnet, daß die Anschlußgebiete 13, die an einander zugewandte Draingebiete 1 benachbarter Transistorpaare 10 angrenzen, an jeweils gegenüberliegenden Seiten der zugehörigen Bitleitung 11 angeordnet sind.

Über die Anschlußgebiete 13 besteht ein Zellkontakt zu einem Speicherelement, das oberhalb der Bitleitungsebene und der Wortleitungsebene angeordnet ist. Das Speicherelement besteht z. B. aus einem Speicherkondensator mit Speicherknoten, Dielektrikum und Zellplatte. Dabei sind das Dielektrikum und die Zellplatte z. B. als durchgehende Schichten oberhalb der Speicherknoten angeorndet.

Die Anschlußgebiete 13 und die zugehörigen Draingebiete 1 sind im Substrat als ein durchgehendes dotiertes Gebiet ausgebildet.

Die Transistorpaare 10a entlang einer ersten Bitleitung 11a sind zu den Transistorpaaren 10b entlang einer zweiten Bitleitung 11b, die der ersten Bitleitung 11a benachbart ist, so versetzt angeordnet, daß die Gateelektroden derjenigen MOS-Transistoren entlang der ersten Bitleitung lla, an deren Draingebieten 1 die Anschlußgebiete 13 an der der zweiten Bitleitung 11b abgewandten Seite angeordnet sind, und die Gateelektroden derjenigen Transistoren entlang der zweiten Bitleitung 11b, an deren Draingebieten 1 die Anschlußgebiete an der der ersten Bitleitung 11a abgewandten Seite angeordnet sind, paarweise jeweils entlang einer Wortleitung 12 angeordnet sind.

Diejenigen Anschlußgebiete 13, die zwischen der ersten Bitleitung 11a und der zweiten Bitleitung 11b angeordnet sind und die einerseits an Draingebiete 1 von MOS-Transistoren entlang der ersten Bitleitung 11a und andererseits an Draingebiete 1 von MOS-Transistoren entlang der zweiten Bitleitung 11b angrenzen, sind auf einer geometrischen Verbindungslinie angeordnet, die parallel zu den Bitleitungen 11 verläuft.

Entlang einer dritten Bitleitung 11c, die der zweiten Bitleitung llb auf der der ersten Bitleitung 11a abgewandten Seite benachbart ist, angeordnete Transistorpaare 10c, mit einem MOS-Transistor, an dessen Draingebiet das Anschlußgebiet an der der zweiten Bitleitung 11b zugewandten Seite angrenzt, und entlang der ersten Bitleitung lla angeordnete Transistorpaare 10a mit MOS-Transistoren, an deren Draingebiet 1 das Anschlußgebiet 13 an der der zweiten Bitleitung 11b zugewandten Seite angrenzt, sind so zueinander versetzt angeordnet, daß die der zweiten Bitleitung 11b zugewandten Anschlußgebiete 13 jeweils paarweise entlang einer geometrischen Verbindungslinie angeordnet sind, die parallel zu den Wortleitungen 12 verläuft.

Fig. 3 zeigt einen Schnitt durch ein Transistorpaar 10 einer erfindungsgemäßen DRAM-Zellenanordnung. Der Schnitt in Fig. 3 ist dabei in einem anderen Maßstab als Fig. 1 und Fig. 2 dargestellt. In dem Substrat 0 sind je Transistorpaar die aktiven Gebiete für zwei MOS-Transistoren realisiert. Dabei sind in dem Substrat 0 Draingebiete 1, Kanalgebiete 2 und ein gemeinsames Sourcegebiet 3 angeordnet. Draingebiet 1, Kanalgebiet 2, Sourcegebiet 3, Kanalgebiet 2 und Draingebiet 1 eines Transistorpaares sind dabei geradlinig angeordnet. An der Oberfläche der Kanalgebiete 2 sind Gateoxide 4 angeordnet. Oberhalb der Gateoxide 4 angeordnete Gateelektroden sind mit Wortleitungen 12 verbunden, die senkrecht zur Schnittebene über die Zellenanordnung verlaufen. Die aktiven Gebiete der Transistorpaare sind gegeneinander durch Feldoxidbereiche 5 isoliert.

In einer Isolationsschicht 15, die die Draingebiete 1 und die Wortleitungen 12 von den Bitleitungen 11 isoliert, sind Bitleitungskontakte 111 zwischen oberhalb der Isolationsschicht 15 verlaufenden Bitleitungen 11 und dem Sourcegebiet 3 realisiert.

Gegen die Bitleitungen 11 durch eine Isolationsschicht 16 getrennt sind Speicherknoten 17 aus z. B. dotierten Polysilizium angeordnet. Die Speicherknoten 17 sind jeweils oberhalb eines MOS-Transistors angeordnet. Oberhalb der Bitleitungskontakte 111 sind benachbarte Speicherknoten 17 unterbrochen.

Die Speicherknoten 17 sind ganzflächig mit einem Speicherdielektrikum 18, z. B. einer Schichtenfolge thermisches SiO₂, Si₃N₄ und thermisches SiO₂, bedeckt. Das Speicherdielektrikum 18 ist ganzflächig von einer Zellplatte 19 aus z. B. dotiertem Polysilizium bedeckt.

Die Speicherknoten 17 sind über Zellkontakte 14, die in dem in Fig. 3 gezeigten Schnitt nicht sichtbar sind, und die Anschlußgebiete 13, die in dem in Fig. 3 gezeigten Schnitt ebenfalls nicht sichtbar sind, mit den Draingebieten 1 elektrisch verbunden.

## Patentansprüche

1. DRAM-Zellenanordnung,
- bei der in einer Bitleitungsebene Bitleitungen (11) und in einer Wortleitungsebene Wortleitungen (12) angeordnet sind,
- bei der in je zwei Speicherzellen, die jeweils einen MOS-Transistor als Zelltransistor und ein Speicherelement umfassen, die MOS-Transistoren als Transistorpaare (10) ausgebildet sind, deren Sourcegebiete (3) miteinander und über einen gemeinsamen Bitleitungskontakt (111) mit einer Bitleitung (11) verbunden sind, und
- bei der die MOS-Transistoren eine lineare Anordnung von Draingebiet (1), Kanalgebiet (2) und Sourcegebiet (3) aufweisen, die in Richtung der Bitleitungen (11) ausgerichtet ist und die im wesentlichen unterhalb einer zugehörigen Bitleitung (11) angeordnet ist, dadurch gekennzeichnet, daß
- jeweils an das Draingebiet (1) ein Anschlußgebiet (13) angrenzt, über das ein Zellkontakt (14) zu dem Speicherelement besteht, und daß
- das Anschlußgebiet (13) jeweils seitlich der zugehörigen Bitleitung (11) angeordnet ist.

2. Anordnung nach Anspruch 1,
bei der die an die Draingebiete (1) eines Transistorpaares (10) angrenzenden Anschlußgebiete (13) an gegenüberliegenden Seiten der zugehörigen Bitleitung (11) angeordnet sind.

3. Anordnung nach Anspruch 2,
bei der die Transistorpaare (10) entlang jeder Bitleitung (11) jeweils so angeordnet sind, daß die Anschlußgebiete (13) die an einander zugewandte Draingebiete benachbarter Transistorpaare (10) angrenzen, an jeweils gegenüberliegenden Seiten der zugehörigen Bitleitung (11) angeordnet sind.

4. Anordnung nach Anspruch 3,
- bei der die Wortleitungen (12) senkrecht zu den Bitleitungen (11) verlaufen,
- bei der die Transistorpaare (10a) entlang einer ersten Bitleitung (11a) zu den Transistorpaaren (10b) entlang einer zweiten Bitleitung (11b), die der ersten Bitleitung (11a) benachbart ist, so versetzt angeordnet sind, daß die jeweils oberhalb des Kanalgebiets (2) angeordneten Gateelektroden derjenigen MOS-Transistoren entlang der ersten Bitleitung (11a), an deren Draingebieten (1) die Anschlußgebiete (13) an der der zweiten Bitleitung (11b) abgewandten Seite angeordnet sind, und die Gateelektroden derjenigen Transistoren entlang der zweiten Bitleitung (11b), an deren Drairgebiete (1) die Anschlußgebiete (13) an der der ersten Bitleitung (11a) abgewandten Seite angeordnet sind, paarweise jeweils entlang einer Wortleitung (12) angeordnet sind.

5. Anordnung nach Anspruch 4,
- bei der zwischen der ersten Bitleitung (11a) und der zweiten Bitleitung (11b) Anschlußgebiete (13), die an Draingebiete (1) von Transistorpaaren (10a) entlang der ersten Bitleitung (11a) angrenzen, und Anschlußgebiete (13), die an Draingebiete (1) von Transistorpaaren (10b) entlang der zweiten Bitleitung (11b) angrenzen, auf einer geometrischen Verbindungslinie angeordnet sind, die parallel zu den Bitleitungen (11) verläuft,
- bei der entlang einer dritten Bitleitung (11c), die der zweiten Bitleitung (11b) auf der der ersten Bitleitung (11a) abgewandten Seite benachbart ist, angeordnete Transistorpaare (10c), an deren Draingebiet (1) das Anschlußgebiet (13) an der der zweiten Bitleitung (11b) zugewandten Seite angrenzt, und entlang der ersten Bitleitung (11a) angeordnete Transitorpaare (10a), an deren Draingebiet (1) das Anschlußgebiet (13) an der der zweiten Bitleitung (11b) zugewanden Seite angrenzt, so zueinander versetzt angeordnet sind, daß die der zweiten Bitleitung (11b) zugewandten Anschlußgebiete (13) jeweils paarweise entlang einer geometrischen Verbindungslinie angeordnet sind, die parallel zu den Wortleitungen (12) verläuft.

6. Anordnung nach Anspruch 5,
- bei der die Breite der Bitleitungen (11) und der Abstand der Bitleitungen (11) im wesentlichen gleich sind,
- bei der die Breite der Wortleitungen (12) und der Abstand der Wortleitungen (12) im wesentlichen gleich ist.

7. Anordnung nach einem der Ansprüche 1 bis 6,
bei der als Speicherelement ein Speicherkondensator mit Speicherknoten (17), Dielektrikum (18) und Zellplatte (19) oberhalb der Wortleitungs- und Bitleitungsebene angeordnet ist.

8. Anordnung nach Anspruch 7,
bei der das Dielektrikum (18) als durchgehende Schicht oberhalb der Speicherknoten (17) angeordnet ist und die Zellplatte (19) als durchgehende Schicht oberhalb aes Dielektrikums angeordnet ist.

9. Anordnung nach einem der Ansprüche 1 bis 8,
bei der jeweils ein Draingebiet (1) und das angrenzende Anschlußgebiet (13) als durchgehendes dotiertes Gebiet in einem Substrat (0) ausgebildet sind.

10. Anordnung nach einem der Ansprüche 1 bis 9,
bei der die MOS-Transistoren eines Transistorpaares (10) ein gemeinsames Sourcegebiet (3) aufweisen.

## Claims

1. DRAM cell arrangement
- in which bitlines (11) are arranged in a bitline plane and word lines (12) are arranged in a wordline plane,
- in which the MOS transistors are constructed in two memory cells respectively, which each comprise an MOS transistor as cell transistor and a memory element, as transistor pairs (10) whose source areas (3) are connected to one another and, via a common bitline contact (111), to a bitline (11), and
- in which the MOS transistors have a linear arrangement of the drain area (1), channel area (2) and source area (3) which is aligned in the direction of the bitlines (11) and is arranged essentially below an associated bitline (11), characterized in that
- a terminal area (13), via which a cell contact (14) to the memory element exists, adjoins the drain area (1) in each case, and in that
- the terminal area (13) is arranged in each case to the side of the associated bitline (11).

2. Arrangement according to Claim 1, in which the terminal areas (13) adjoining the drain areas (1) of a transistor pair (10) are arranged on opposite sides of the associated bitline (11).

3. Arrangement according to Claim 2, in which the transistor pairs (10) are respectively arranged along each bitline (11) in such a way that the terminal areas (13) which adjoin mutually facing drain areas of adjacent transistor pairs (10) are arranged on respectively opposite sides of the associated bitline (11).

4. Arrangement according to Claim 3,
- in which the wordlines (12) extend perpendicular to the bitlines (11)
- in which the transistor pairs (10a) along a first bitline (11a) are arranged offset relative to the transistor pairs (10b) along a second bitline (11b), which is adjacent to the first bitline (11a), in such a way that the gate electrodes, respectively arranged above the channel area (2), of those MOS transistors along the first bitline (11a) on whose drain areas (1) the terminal areas (13) on the side averted from the second bitline (11b) are arranged, and the gate electrodes of those transistors along the second bitline (11b) on whose drain areas (1) the terminal areas (13) on the side averted from the first bitline (11a) are arranged, are arranged in pairs along a wordline (12) in each case.

5. Arrangement according to Claim 4,
- in which between the first bitline (11a) and the second bitline (11b) terminal areas (13) which adjoin drain areas (1) of transistor pairs (10a) along the first bitline (11a), and terminal areas (13), which adjoin drain areas (1) of transistor pairs (10b) along the second bitline (11b) are arranged on a geometrical connecting line which extends parallel to the bitlines (11),
- in which transistor pairs (10c) arranged along a third bitline (11c), which is adjacent to the second bitline (11b) on the side averted from the first bitline (11a), and whose drain area (1) is adjoined by the terminal area (13) on the side facing the second bitline (11b), and transistor pairs (10a) arranged along the first bitline (11a) and whose drain area (1) is adjoined by the terminal area (13) on the side facing the second bitline (11b) are arranged offset relative to one another in such a way that the terminal areas (13) facing the second bitline (11b) are arranged respectively in pairs along a geometrical connecting line which extends parallel to the wordlines (12).

6. Arrangement according to Claim 5,
- in which the width of the bitlines (11) and the spacing of the bitlines (11) are essentially the same,
- in which the width of the wordlines (12) and the spacing of the wordlines (12) are essentially the same.

7. Arrangement according to one of Claims 1 to 6, in which a storage capacitor having storage nodes (17), a dielectric (18) and cell plate (19) is arranged as memory element above the wordline plane and the bitline plane.

8. Arrangement according to Claim 7, in which the dielectric (18) is arranged as a continuous layer above the storage nodes (17) and the cell plate (19) is arranged as a continuous layer above the dielectric.

9. Arrangement according to one of Claims 1 to 8, in which in each case one drain area (1) and the adjoining terminal area (13) are constructed as a continuous doped area in a substrate (0).

10. Arrangement according to one of Claims 1 to 9, in which the MOS transistors of a transistor pair (10) have a common source area (3).

## Revendications

1. Configuration de cellules Dram
- dans laquelle des lignes de binaires (11) sont disposées dans un plan de lignes de binaires et des lignes de mots (12) sont disposées dans un plan de lignes de mots,
- dans laquelle, à chaque fois que deux cellules de mémoire comportent chacune un transistor MOS comme transistor de cellule et un élément de mémoire, les transistors MOS sont conformés comme des paires de transistors (10) dont les zones de source (3) sont reliées entre elles ainsi qu'à une ligne de binaire (11) par l'intermédiaire d'un contact commun de ligne de binaire (111) et
- dans laquelle les transistors MOS présentent une disposition linéaire de la zone du drain (1), de la zone du canal (2) et de la zone de la source (3), qui est tournée vers les lignes de binaires (11) et qui, pour l'essentiel, est disposée sous une ligne de binaire (11) correspondante, caractérisé en ce que
- la zone du drain (1) est chaque fois contiguë à une zone de connexion (13) qui établit un contact de cellule (14) avec l'élément de mémoire et en ce que
- la zone de connexion (13) est chaque fois disposée à côté de la ligne de binaire (11) correspondante.

2. Dispositif selon la revendication 1, dans lequel les zones de connexion (13) jouxtant les zones de drain (1) d'une paire de transistors (10) sont disposées sur des côtés opposés de la ligne de binaire (11) correspondante.

3. Dispositif selon la revendication 2, dans lequel les paires de transistors (10) sont disposées le long de chaque ligne de binaire (11) de sorte que les zones de connexion (13) qui jouxtent les zones de drain tournées les unes vers les autres de paires de transistors (10) voisines sont disposées sur des côtés opposés de la ligne de binaire (11) correspondante.

4. Dispositif selon la revendication 3,
- dans lequel les lignes de mots (12) sont perpendiculaires aux lignes de binaires (11),
- dans lequel les paires de transistors (10a) sont disposées de manière décalée le long d'une première ligne de binaire (11a) par rapport aux paires de transistors (10b) situées le long d'une deuxième ligne de binaire (11b) qui est proche de la première ligne de binaire (11a) de sorte que les électrodes de grille - qui sont chaque fois placées au-dessus de la zone de canal (2) - des transistors MOS situés le long de la première ligne de binaire (11a) pour lesquels les zones de connexion (13) sont disposées à proximité de leurs zones de drain (1) du côté opposé à la deuxième ligne de binaire (11b) et les électrodes de grille des transistors situés le long de la deuxième ligne de binaire (11b), pour lesquels les zones de connexion (13) sont disposées à proximité de leurs zones de drain (1) du côté opposé à la première ligne de binaire (11a) sont disposées par paires chaque fois le long d'une ligne de mots (12).

5. Dispositif selon la revendication 4,
- dans lequel, entre la première ligne de binaire (11a) et la deuxième ligne de binaire (11b), des zones de connexion (13), qui jouxtent des zones de drain (1) de paires de transistors (10a) le long de la première ligne de binaire (11a) et des zones de connexion (13) qui jouxtent des zones de drain (1) de paires de transistors (10b) le long de la deuxième ligne de binaire (11b) sont disposées sur une ligne de jonction géométrique qui est parallèle aux lignes de binaires (11),
- dans lequel, le long d'une troisième ligne de binaire (11c) qui est proche de la deuxième ligne de binaire (11b) du côté opposé à la première ligne de binaire (11a), des paires de transistors (10c) pour lesquels la zone de connexion (13) jouxte leurs zones de drain (1) du côté tourné vers la deuxième ligne de binaire (11b) et le long de la première ligne de binaire (11a), des paires de transistors (10a) pour lesquels la zone de connexion (13) jouxte leurs zones de drain (1) du côté tourné vers la deuxième ligne de binaire (11b), sont disposées de manière décalée les unes par rapport aux autres de sorte que les zones de connexion (13) tournées vers la deuxième ligne de binaire (11b) sont chaque fois disposées par paires le long d'une ligne de jonction géométrique qui est parallèle aux lignes de mots (12).

6. Dispositif selon la revendication 5,
- dans lequel la largeur des lignes de binaires (11) et la distance entre les lignes de binaires (11) sont essentiellement identiques,
- dans lequel la largeur des lignes de mots (12) et la distance entre les lignes de mots (12) sont essentiellement identiques.

7. Dispositif selon l'une des revendications 1 à 6,
dans lequel un condensateur de mémoire avec noeuds de mémoire (17), diélectrique (18) et plaque de cellule (19) est disposé comme élément de mémoire au-dessus du plan des lignes de binaires et des lignes de mots.

8. Dispositif selon la revendication 7,
dans lequel le diélectrique (18) est disposé comme couche continue au-dessus des noeuds de mémoire (17) et la plaque de cellule (19) est disposée comme couche continue au-dessus du diélectrique.

9. Dispositif selon l'une des revendications 1 à 8,
dans lequel une zone de drain (1) et la zone de connexion (13) contiguë (13) sont conformées dans un substrat (0) comme zone dopée continue.

10. Dispositif selon l'une des revendications 1 à 9,
dans lequel les transistors MOS d'une paire de transistors (10) présentent une zone de source (3) commune.
